# EUROPÄISCHE PATENTANMELDUNG

(11) **EP 1 808 909 A1**
(43) Veröffentlichungstag der Anmeldung: **18.07.2007**
(21) Anmeldenummer: 06000436.3
(22) Anmeldetag: 11.01.2006
(51) Int. Cl.: H01L 51/52

(54) **Elekrolumineszente Lichtemissionseinrichtung**

(71) Anmelder: Novaled AG, 01307 Dresden (DE)
(72) Erfinder: Schwartz, Gregor, 01159 Dresden (DE); Harada, Kentaro, 01307 Dresden (DE); Walzer, Karsten, 01099 Dresden (DE); Pfeiffer, Martin, 01139 Dresden (DE); Leo, Karl, 01219 Dresden (DE)
(74) Vertreter: Bittner, Thomas L.

(57) **Zusammenfassung**

Die Erfindung betrifft elektrolumineszente Lichtemissionseinrichtungen, die dadurch gekennzeichnet sind, dass sie mindestens eine Dünnschicht aus Fullerenen, dotiert mit einem organischen Dotanden, als funktionale Schicht enthalten. Mit der dotierten Fullerenschicht können wesentliche Vereinfachungen im strukturellen Aufbau organischer elektrolumineszenter Lichtemissionseinrichtungen erreicht und damit ihr Produktionsprozess effizienter gemacht werden. Ein Merkmal der Erfindung ist die Ausnutzung der hohen Leitfähigkeit der dotierten Fullerenschichten unter anderem dadurch, dass die dotierte Fullerenschicht als Elektrode verwendet wird. Besonders in der Anwendung als transparente, separat kontaktierbare Zwischenelektrode in vertikal gestapelten organischen Leuchtdioden hat diese dotierte Fullerenschicht Vorteile gegenüber anderen Ansätzen.

## Beschreibung

Die Erfindung betrifft elektrolumineszente Lichtemissionseinrichtungen, die Dünnschichten aus Fullerenen und Fullerenderivaten, dotiert mit einem organischen Dotanden, als funktionale Schichten enthalten.

Elektrolumineszenz organischer Materialien ist seit ihrer ersten Beobachtung 1953 (Bernanose et al., J. Chim. Phys. 1953, 50, 65) zu einem intensiv bearbeiteten Forschungsgebiet geworden. Die bekannten Vorteile organischer Materialien für die Lichterzeugung wie zum Beispiel geringe Reabsorption, hohe Quantenausbeuten oder auch die Möglichkeit, durch relativ einfache Variation der Molekülstruktur das Emissionspektrum anzupassen, konnten in den letzten Jahren durch beständige Entwicklung in der Materialforschung und Umsetzung neuer Konzepte zum effektiven Injizieren und Transportieren der Ladungsträger in die aktive Emissionsschicht eines organischen Leuchtelements ausgenutzt werden. Erste Anzeigeeinrichtungen, welche auf solchen so genannten organischen Leuchtdioden basieren, haben bereits den Weg auf den Markt gefunden und organische Leuchtdioden werden in Zukunft als Konzept neben Flüssigkristallanzeigen und Anzeigen aus anorganischen Leuchtdioden fest etabliert sein. Ein weiterer Markt, welcher den organischen Leuchtdioden aufgrund ihrer speziellen Eigenschaft, Licht großflächig und homogen in den Halbraum emittieren zu können, offen steht, ist das Gebiet der Beleuchtung.

### Stand der Technik

Der Schritt zur Serienreife erhöht den Druck, einzelne Kostenfaktoren des Produkts, Kosten des Rohmaterials oder auch Schritte im Produktionsprozess zu minimieren. Als ein Hauptkostenfaktor wird das zurzeit üblicherweise verwendete transparente Elektrodenmaterial Indium-Zinnoxid (ITO) sowohl aufgrund des hohen Bedarfs an auf der Erde intrinsisch selten vorkommendem und daher teurem Indium als auch wegen des aufwendigen Aufbringungsprozesses des ITO durch Sputtern auf das Substrat angesehen. Soll eine transparente Leuchtdiode hergestellt werden, d.h. soll ITO also auch als Gegenelektrode auf die organischen Schichten aufgebracht werden, gestaltet sich der Produktionsprozess noch schwieriger, da aufwendige Maßnahmen zum Schutz der organischen Schichten vor Beschädigung durch die beim Sputtern auftretenden energiereichen Partikel notwendig sind.

Elschner et al. beispielsweise (Offenlegungsschrift DE 103 35 727 A1) schlagen eine hochleitfähige Polymerschicht zur alternativen Verwendung als Elektrode vor. Solche flüssig aufgebrachten Polymerschichten erreichen Leitfähigkeiten von bis zu 550 S/cm. Damit ist offensichtlich das Problem des teuren Ausgangsmaterials gelöst, da Indium nicht verwendet wird. Nachteilig an dieser Erfindung ist allerdings, dass nach wie vor ein zusätzlicher Schritt der Aufbringung der Polymerelektrode auf das Substrat notwendig ist. Insbesondere für die Herstellung von organischen Leuchtdioden, welche aus einer Folge von amorphen Dünnschichten bestehen, die im Vakuum aufgedampft werden, stellt das Aufschleudern der Polymerelektrode unter Normaldruck unter gleichzeitig hoch staubfreien Bedingungen eine Verkomplizierung und damit Verteuerung des Produktionsablaufs dar. Als unmöglich erscheint mit einem solchen Verfahren außerdem die Realisierung von transparenten Leuchtdioden, da beim Aufschleudern der Polymerschicht Lösungsmittel verwendet werden, welche die darunter liegenden organischen Dünnschichten im Allgemeinen mit anlösen und damit die Einrichtung unabsehbar verändern oder gar zerstören würden.

Eine Weiterentwicklung der transparenten organischen Leuchtdiode sind gestapelte transparente Leuchtdioden (siehe z.B. Gu et al. J. Appl. Phys. 1999, 86, 4067). Es wird dabei eine Anzahl transparenter Leuchtdioden sequentiell auf ein Substrat gestapelt aufgebracht, wobei jeweils zwei aufeinander folgende Leuchtdioden eine transparente Elektrode gemeinsam haben. Um die Leuchtdioden des Stapels einzeln ansteuern zu können, werden transparente Elektroden seitlich herausgeführt und kontaktiert. Dazu ist eine hohe laterale Leitfähigkeit der Elektroden notwendig, weshalb dazu üblicherweise ITO verwendet wird. Dies führt zu den gleichen bereits genannten Problemen wie bei den transparenten Leuchtdioden.

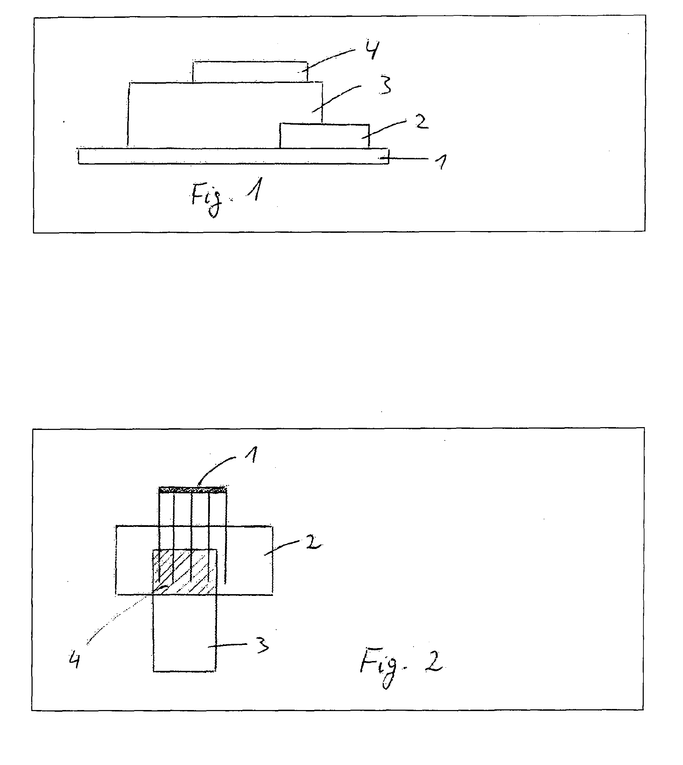

In der Literatur sind jedoch bisher aufdampfbare organische Schichten mit Leitfähigkeiten, die mit den der aus der flüssigen Phase aufgebrachten Materialien vergleichbar sind, nicht bekannt. Aufgedampfte organische Halbleiter haben besonders in ihrer amorphen Phase im Allgemeinen eine sehr geringe Leitfähigkeit, so dass trotz der effektiven Erhöhung der Leitfähigkeit durch Dotierung mit geeigneten Dotanden um mehrere Größenordnungen die laterale Bewegung der Ladungsträger in einer vertikal unter Spannung stehenden Schicht mit teilweise nicht überlappenden Elektroden als vernachlässigbar gilt. Siehe dazu Fig.1, welche eine schematische Queransicht der beschriebenen Anordnung zeigt. Hier bezeichnen
(1) ein elektrische nicht leitendes Substrat,
(2) und (4) einander zumindest teilweise nicht überlappende Elektroden und
(3) eine oder mehrere organische Schichten im elektrischen Feld der beiden Elektroden (2) und (4).

Für solche Anordnungen reichen die bisher berichteten Leitfähigkeiten von aufgedampften organischen Schichten mit hoher Transparenz nicht aus, um ausreichenden lateralen Transport zu erreichen. Zwar führt die hohe intrinsische Elektronenbeweglichkeit von C₆₀ bei Dotierung mit geeigneten donatorartigen Molekülen (siehe z.B. Werner et al., Adv. Func. Mater. 2004, 14,255) zu hohen effektiven Beweglichkeiten und Leitfähigkeiten (teilweise im Bereich von σ =0,1S/cm liegen können. Diese reichen jedoch bei einer z.B. durch Drucktechniken darstellbaren Auflösung von ca 100 µm für leitende Stege bei weitem nicht aus (s. Ausführungsbeispiele unten).

Wichtige Faktoren für die Effizienz elektrolumineszenter Lichtemissionseinrichtungen sind neben der Ausbeute bei der Umwandlung elektrischer Energie in der Emissionsschicht in Licht die Injektion von Elektronen aus der Kathode und von Löchern aus der Anode in die jeweils angrenzende Schicht sowie die Fähigkeit der einzelnen Schichten zum Ladungsträgertransport. Es hat sich gezeigt, dass im Allgemeinen ein organisches Material nicht alle notwendigen Eigenschaften in sich vereint, sodass für die unterschiedlichen Funktionen teilweise verschiedene Materialien verwendet werden müssen, um ein effizient funktionierendes Bauteil zu erhalten.

Als Löcherinjektions- und -transportmaterialien (hole transport materials, HTM) kommen üblicherweise Materialien mit Austrittsarbeiten IP>4.5eV und Löcherbeweglichkeiten µₕ>1×10⁻⁵ cm²/Vs zum Einsatz, um gute Injektion aus der Anode (ITO) und schnellen Abtransport der Löcher zu ermöglichen. Beispiele für HTMs sind Phtalocyanine wie CuPc, sogenannte starburst-Moleküle wie MTDATA oder auch Benzidine wie TPD und NPD (siehe z.B. Adachi et al. (2003), "Design Concept of Molecular Materials for High-Performance OLED", in: Shinar (Hrsg.), Organic Light-Emitting Devices, Springer, New York, S.43).

Demgegenüber kommen als Elektroneninjektions- und - transportmaterialien (electron transport materials, ETM) solche mit Elektronenbeweglichkeiten µₑ>1x10⁻⁶cm²/Vs und Elektronenaffinitäten EA<3.5eV zum Einsatz. Hierbei ist die geeingnete Wahl der EA wesentlich durch die EA des zum Einsatz kommenden Emittermaterials bestimmt. Typische Beispiele sind Oxadiazole, Triazole, Quinoline oder Thiophene (siehe z.B. Hughes et al., J. Mater. Chem. 2005, 15, 94).

Als vorteilhaft hat sich die Dotierung von Löchertransportmaterialien mit akzeptorartigen Dotanden bzw. von Elektronentransportmaterialien mit donatorartigen Dotanden erwiesen (Pfeiffer et al., Org. Electron. 2003, 4, 89). Durch die dadurch erreichte Erhöhung der Konzentration freier Ladungsträger in der Schicht werden sowohl die Leitfähigkeit als auch die effektive Ladungsträgerbeweglichkeit verbessert. Verwendet man eine dotierte organische Schicht in einem Schottkykontakt, wird durch die ebenfalls erhöhte Raumladungsdichte die Verarmungszone gegenüber dem undotierten Fall wesentlich dünner. Die Injektion der Ladungsträger aus einer Elektrode in die Transportschicht kann somit durch Dotierung der Transportschicht entscheidend verbessert werden. Nicht zuletzt erlangt man dadurch eine größere Unabhängigkeit von der Austrittsarbeit in der Wahl des Elektrodenmaterials, so dass eine größere Auswahl an Materialien als Elektrodenmaterial verwendet werden kann.

Fullerene, insbesondere das Buckminsterfulleren C₆₀, werden seit ihrer Entdeckung 1985 ebenfalls intensiv erforscht und kommen beispielsweise in organischen Solarzellen (siehe zum Beispiel US 6,580,027 B2, Forrest et al.) als Akzeptormaterial zum Einsatz.

Krätschmer und Huffman entwickelten 1991 ein Verfahren zur Herstellung von C₆₀ und C₇₀ in größeren Mengen (WO 92/04279). Seitdem werden Herstellungsverfahren für Fullerene beständig weiterentwickelt, sodass heutzutage Fullerene als sehr kostengünstiges Ausgangsmaterial zur Verfügung stehen.

In organischen Leuchtdioden gibt es bisher nur wenige Versuche, Fullerene einzusetzen. Dabei zeigt sich, dass die Verwendung von Fullerenen in organischen Leuchtdioden nicht ohne weiteres sinnvoll ist bzw. in vielen Fällen zu einer Verschlechterung der Eigenschaften führt.

Beispielsweise haben Day et al. (Thin Solid Films 2002, 410, 159) gezeigt, dass sogar Submonolagen von C₆₀ zwischen der ITO-Anode und der Löchertransportschicht die Injektion erschweren und zu einer Verschlechterung der Bauteilcharakteristik führen. Demgegenüber finden Hong et al. (Appl. Phys. Lett. 2005, 87, 063502) in nur Löcher leitenden Bauteilen eine Erhöhung der Stromdichte bei gleicher Spannung, wenn eine dünne C₆₀-Schicht zwischen die Anode und die organische Schicht hinzugefügt wird, wobei die Autoren dies auf einen Oberflächendipol und nicht auf eine Schichteigenschaft des Fullerens zurückführen. In diesem Fall ist also offensichtlich, dass die Verwendung in einer Schicht nicht zweckdienlich ist.

Yuan et al. (Appl. Phys. Lett. 2005, 86, 143509) haben gezeigt, dass Löcher von der ITO-Anode in eine mit 5 Gewichtsprozenten C₆₀ dotierte NPB-Schicht besser injiziert werden als in eine reine CuPc-Schicht. Noch besser wird die Injektion allerdings, wenn man eine undotierte NPB-Schicht verwendet, so dass wiederum die Verwendung einer C₆₀ Schicht nicht nahe gelegt wird. Lee et al. (Appl. Phys. Lett. 2005, 86, 063514) zeigen, dass C₆₀ in TDAPB als schwacher Elektronenakzeptor funktioniert und die effektive Löcherbeweglichkeit erhöht wird. Da außerdem freie Elektronen aus Leckströmen in einer OLED mit C₆₀:TDAPB als Löchertransportschicht effektiv von C₆₀ eingefangen werden und somit das TDAPB nicht destabilisieren können, erhöht sich die Lebensdauer bei gleicher Anfangshelligkeit.

Der Verwendung von C₆₀ als Elektronentransportschicht steht trotz der hohen Elektronenbeweglichkeit µₑ~8x10⁻²cm²/Vs zunächst die relativ große Elektronenaffinität von ~4eV entgegen. Lu et al. (US 2004-214041 A1) verwenden C₆₀ dennoch in Verbindung mit einer LiF/Al Kathode als Elektronentransportschicht, wobei die LiF Injektionsschicht dabei unbedingt erforderlich ist. Yasuhiko et al. (PCT WO 2005-006817 A1) verwenden separat hergestelltes Li enthaltendes C₆₀ als Elektronentransportschicht. Solche Schichten sind jedoch aufgrund der hohen Diffusivität des Li nicht stabil und damit für Bauelemente nicht geeignet. Zusammenfassend kann also festgestellt werden, dass die Verwendung von C₆₀ als Schicht in organischen Leuchtdioden von den Literaturergebnissen als nachteilig beschrieben wird.

### Aufgabenstellung

Es ist Ziel der vorliegenden Erfindung, alternative Materialkombinationen anzugeben, welche in elektrolumineszenten Lichtemissionseinrichtungen unter Vorgabe einer Funktion verwendet werden können. Dabei soll durch die Verwendung in der jeweiligen Funktion eine Vereinfachung von Produktionsschritten erreicht werden bzw. eine Alternative zu teureren Materialien angegeben werden und damit die elektrolumineszente Lichtemissionseinrichtung insgesamt kostengünstiger herzustellen sein.

Erfindungsgemäß wird die Aufgabe dadurch gelöst, dass als Materialkombination eine Schicht aus Fullerenen, dotiert mit organischen donatorartigen Dotanden, verwendet wird.

Hierbei wird die überraschende experimentelle Feststellung ausgenutzt, dass mit dem Fulleren C₆₀ und Dotanden, wie sie beispielsweise von Werner et al. WO2005086251 A2 vorgeschlagen werden, Leitfähigkeiten von über 2S/cm erreicht werden können.

Derartig hohe Leitfähigkeiten führen dazu, dass die laterale Ausdehnung des Ladungsträgerstromes in der Anordnung nach Fig.1 bis zu mehrere hundert Mikrometer und mehr betragen kann. Damit sind die Voraussetzungen erfüllt, um eine solche organisch dotierte hochleitfähige Schicht als Elektrode verwenden zu können.

Wird die Dicke dieser dotierten Fullerenschicht kleiner oder nicht viel größer als 100nm gewählt, so ist die Schicht im sichtbaren Wellenlängenbereich noch ausreichend transparent. Sie läßt sich also insbesondere in elektrolumineszenten Lichtemissionseinrichtungen als transparente Elektrode verwenden.

Die Schicht wird vorzugsweise im Hochvakuum durch gleichzeitiges Verdampfen des Fullerens und des organischen Dotanden, also mit dem für organische Dünnschichten üblichen Verfahren, aufgebracht. Damit fügt sich die Aufbringung einer solchen Elektrode ohne Mehraufwand in den Produktionsprozess einer organischen elektrolumineszenten Lichtemissionseinrichtung ein.

Sollen elektrolumineszente Lichtemissionseinrichtungen mit größeren lateralen Maßen der lichtemittierenden Fläche hergestellt werden als die hochleitfähige dotierte Fullerenschicht durch laterale Verbreiterung des Ladungsträgerstromes überbrücken kann, so kann in direktem Kontakt zu dieser dotierten Fullerenschicht ein Gitter aus Metall aufgebracht werden. Dabei kann die Breite der Gitterstege so klein gewählt werden, dass die Stege im lichtemittierenden Betrieb der elektrolumineszenten Lichtemissionseinrichtung mit dem menschlichen Auge nicht mehr wahrzunehmen sind. Ein ausreichend kleines Verhältnis der Gitterstegbreite zum Abstand der Stege ist etwa 1 zu 10. Bei einer mit einer hochleitfähigen dotierten Fullerenschicht überbrückbaren Distanz von mehreren hundert Mikrometern ergibt sich eine Stegbreite von einigen zehn Mikrometern. Die Herstellung von Metallstegen mit solchen Dimensionen ist heutzutage unkompliziert durch einfache Verdampfung des Metalls durch Schattenmasken möglich. Noch günstiger sind Druckmethoden, die nach momentanem Stand der Technik Stegabstände in der Größenordnung von ca. 100 Mikrometer erlauben.

Um eine geschlossene Metallschicht zu bilden, müssen die Stege üblicherweise einige zehn Nanometer dick sein. Somit wird eine entsprechend große Unebenheit für die folgenden Schichten eingeführt, da diese ebenfalls Dicken im Bereich von etwa zehn bis hundert Nanometern aufweisen. Es sollten daher eigentlich vermehrt Kurzschlüsse auftreten, was jedoch überraschenderweise bei unseren Versuchen nicht der Fall war.

Ebenfalls überraschend ist die Tatsache, dass trotz der mit den Stegen eingeführten Unebenheiten eine lateral homogen leuchtende organische Leuchtdiode auf solch eine Elektrode aufgebracht werden kann. Die in organischen Schichten normalerweise auftretenden raumladungsbegrenzten Ströme skalieren mit l/d³ (d ist die Schichtdicke). Die Unebenheiten sollten sich daher eigentlich auch durch eine nicht homogen leuchtende Fläche bemerkbar machen, da die Helligkeit direkt proportional zum fließenden Strom ist. Dies ist jedoch mit dem bloßen Auge nicht zu beobachten, wie unsere Versuche gezeigt haben. Entscheidend für die Helligkeitsverteilung zwischen den Stegen sind nur die Leitfähigkeit der dotierten Fullerenschicht und der Abstand der Stege. Ist die Leitfähigkeit ausreichend groß und wird der Abstand der Steige geeignet gewählt, wirkt sich der Spannungsabfall nicht sichtbar auf die Helligkeit zwischen den Stegen aus.

Bei der angegebenen Materialkombination handelt es sich mit Fullerenen und organischen Dotanden um Materialien, welche mit denselben Verfahren aufgebracht werden können wie übliche Dünnschichten in organischen elektrolumineszenten Lichtemissionseinrichtungen. Daher ist eine Aufbringung der dotierten Fullerenschicht im Anschluss an vorhergehend aufgebrachte organische Dünnschichten ohne Unterbrechung des Produktionsflusses und ohne die vorangehend aufgebrachten Dünnschichten schützende Maßnahmen möglich.

Daraus ergeben sich weitere vorteilhafte Ausgestaltungen, welche den Unteransprüchen entnommen werden können.

In eine mit donatorartigen organischen Molekülen dotierte Fullerenschicht lassen sich Elektronen aus einem Metall mit hoher Austrittsarbeit besser injizieren als in eine reine Fullerenschicht. Daher kann eine Injektionsschicht zwischen dem Metall und der dotierten Fullerenschicht, wie zum Beispiel LiF weggelassen werden, welche aufgrund der leicht möglichen Diffusion des Li in die Fullerenschicht oder auch durch die Fullerenschicht hindurch in angrenzende Schichten sowie durch die allgemein bekannte hohe Reaktivität des Li und die damit jeweils verbundenen unerwünschten oder nicht kontrollierbaren Effekte nachteilig ist. Somit ist eine mit donatorartigen organischen Molekülen dotierte Fullerenschicht vorteilhaft dafür geeignet, um als Elektronen transportierende Schicht in einer elektrolumineszenten Lichtemissionseinrichtung zu funktionieren. Überraschend dabei ist, dass dies trotz der eigentlich für übliche Emittermaterialien zu hohen Elektronenaffinität funktioniert, wie wir weiter unten in einem Beispiel zeigen.

Eine wesentliche Vereinfachung der Struktur und damit des Herstellungsprozesses einer elektrolumineszenten Lichtemissionseinrichtung besteht darin, die dotierte Fullerenschicht sowohl in der Funktion als transparente Elektrode als auch in der Funktion als Elektronen transportierende Schicht zu verwenden, was damit gleichzusetzen ist, dass eine der genannten funktionalen Schichten weggelassen werden kann.

Für den Fall, dass die elektrolumineszente Lichtemissionseinrichtung mit sehr hohen Stromdichten betrieben werden soll, etwa, um in der Gesamtheit der in der Licht emittierenden Schicht vorhandenen Emittermoleküle eine Besetzungsinversion zu erreichen wie sie für stimulierte Emission nötig ist, ist es von Vorteil, eine dotierte Fullerenschicht als Ladungsträgertransportmaterial zu verwenden, da diese im Gegensatz zu anderen organischen Materialien aufgrund ihrer hohen effektiven Ladungsträgerbeweglichkeit und Leitfähigkeit dazu in der Lage ist, sehr hohe Stromdichten zu tragen.

### Ausführungsbeispiele

Die Erfindung wird im Folgenden durch Ausführungsbeispiele näher erläutert werden. Erfindungsgemäße vorteilhafte Ausgestaltungen beinhalten jeweils eine Abfolge von Schichten:

Ausführungsbeispiel 1 (Fullerenschicht als Elektrode):
1. Transparentes Glassubstrat
2. Metallstreifen, Abstände 450µm, Breiten 50µm
3. mit organischen donatorartigen Molekülen dotierte Fullerenschicht
4. nicht geschlossene Goldschicht, mittlere Dicke 1nm
5. Löchertransportschicht
6. Elektronenblockschicht
7. Licht emittierende Schicht
8. Löcherblockschicht
9. Elektronentransportschicht
10. Aluminiumkathode

Zur Veranschaulichung zeigt Fig.2 eine Draufsicht dieser Anordnung. Die Anordnung emittiert bei angelegter Spannung (Pluspol an die Metallstreifen (1), Minuspol an die Aluminiumkathode (3)) Licht durch das Glassubstrat. Die leuchtende Fläche (schraffiert, 4) ist dabei durch den lateralen Überlapp zwischen Aluminiumelektrode und dotierter Fullerenschicht (2) bestimmt. Ist die Leitfähigkeit von (2) größer als 0,5 S/cm, dann erscheint die Helligkeit der leuchtenden Fläche dem Betrachter mit bloßem Auge homogen. Die nicht geschlossene Goldschicht (4. Schicht der Anordnung) dient nur der Verbesserung der Strom-Spannungs-Charakteristik des Bauteils und kann ohne Beeinträchtigung der wesentlichen Merkmale der Erfindung weggelassen werden.

Konkretes Beispiel 1a (zu Ausführungsbeispiel 1):
1. Transparentes Glassubstrat
2. Chromstreifen, Abstände 450µm, Breiten 50µm, Dicke 10nm
3. 30nm C₆₀ dotiert mit 2 mol% [Ru(t-butyl-trpy)₂]⁰
4. nominell 1nm Gold (keine geschlossene Schicht)
5. 95nm MeO-TPD dotiert mit 4 mol% F₄-TCNQ
6. 10nm Spiro-TAD
7. 20nm BAlq dotiert mit 20 Gewichts-% Ir(piq)₃
8. 10nm BPhen
9. 65nm BPhen dotiert mit Cs
10. 100nm Al

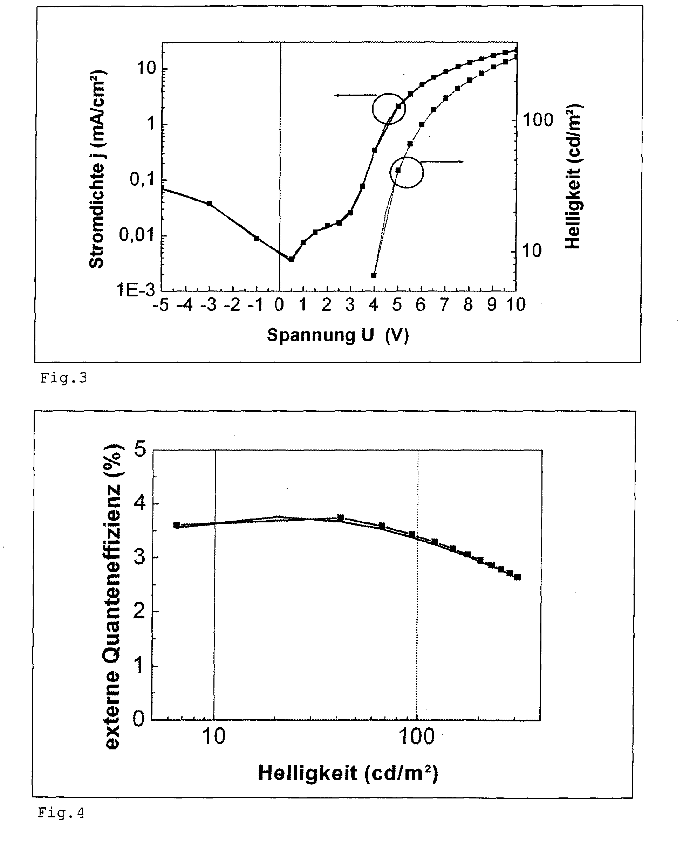

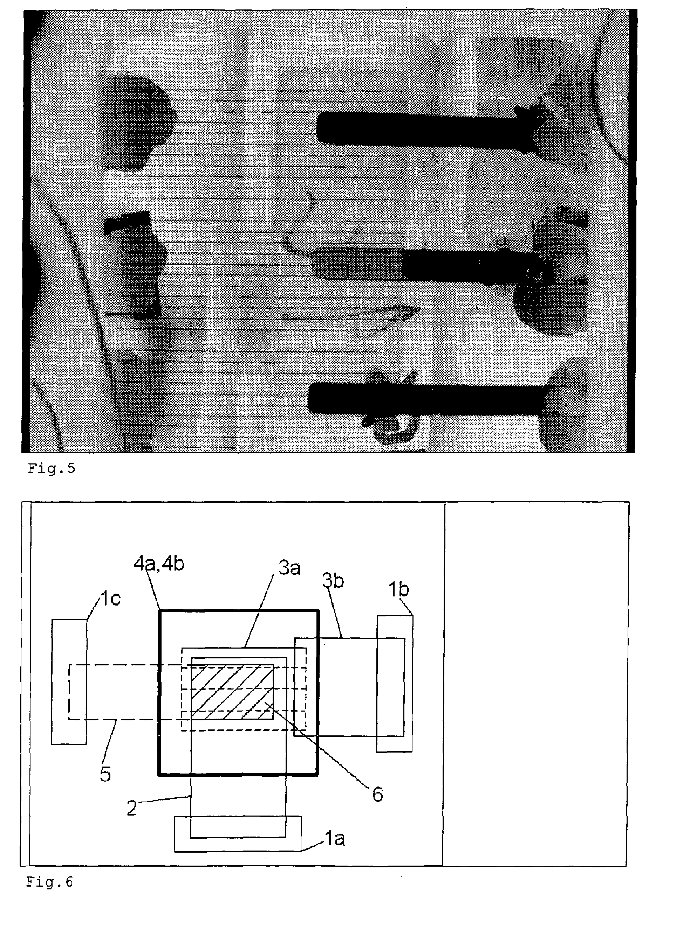

Die Leitfähigkeit der Schicht (3.) betrug weniger als 0,5S/cm. Damit ist der Spannungsabfall zwischen den Stegen so groß, dass auch ein Helligkeitsabfall in den Zwischenräumen zu sehen ist, wie Fig.5 zeigt. In Fig.3 und 4 sind weiterhin Kenndaten zu diesem Beispiel gezeigt.

Ausführungsbeispiel 2 (Fullerenschicht als Elektronenleitschicht):
1. Transparentes Glassubstrat
2. ITO Anode
3. Löchertransportschicht
4. Elektronenblockschicht
5. Licht emittierende Schicht
6. Löcher- und Exzitonenblockschicht
7. mit organischen donatorartigen Molekülen dotierte Fullerenschicht
8. Aluminiumkathode

In dieser Anordnung wird die dotierte Fullerenschicht als Elektronen transportierende Schicht verwendet. Bei Anlegen einer Spannung (Pluspol an die Anode, Minuspol an die Kathode) emittiert die Anordnung Licht durch das Glassubstrat. Die Aluminiumkathode kann auch weggelassen werden und der Minuspol an die dotierte Fullerenschicht angelegt werden. Diese Anordnung emittiert dann Licht sowohl durch das Glassubstrat als auch durch die gegenüberliegende Seite der Anordnung. Außerdem ist die Anordnung ohne angelegte Spannung transparent.

Konkretes Beispiel 2a (zu Ausführungsbeispiel 2):
1. Transparentes Glassubstrat
2. ITO Anode
3. 60nm MeO-TPD dotiert mit 4 mol% F₄-TCNQ
4. 10nm Spiro-TAD
5. 20nm BAlq dotiert mit 20 Gewichts-% Ir(piq)₃
6. 10nm BPhen
7. 50nm C₆₀ dotiert mit 4 mol% AOB
8. 100nm Al

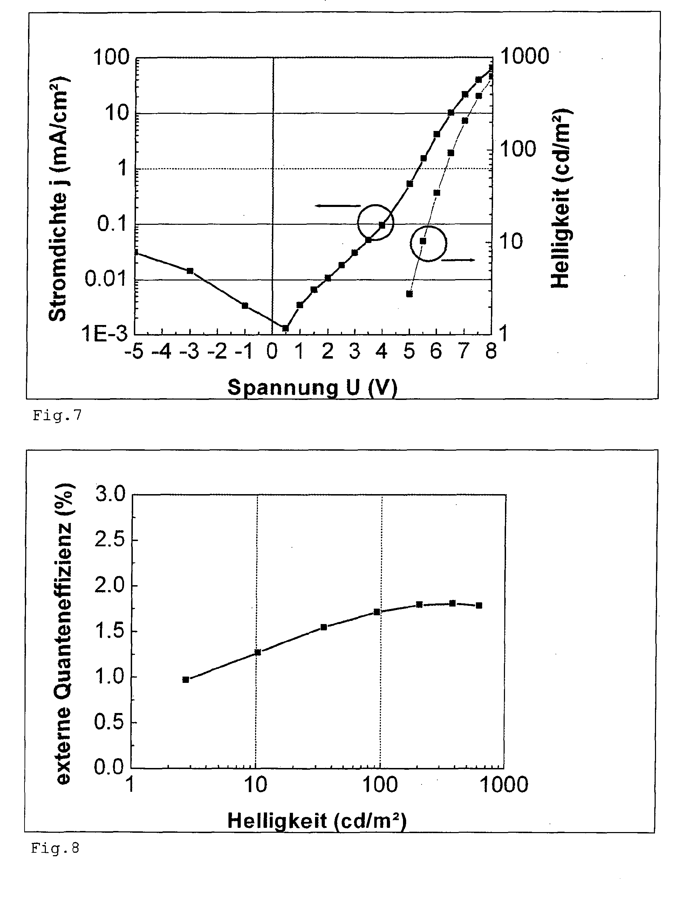

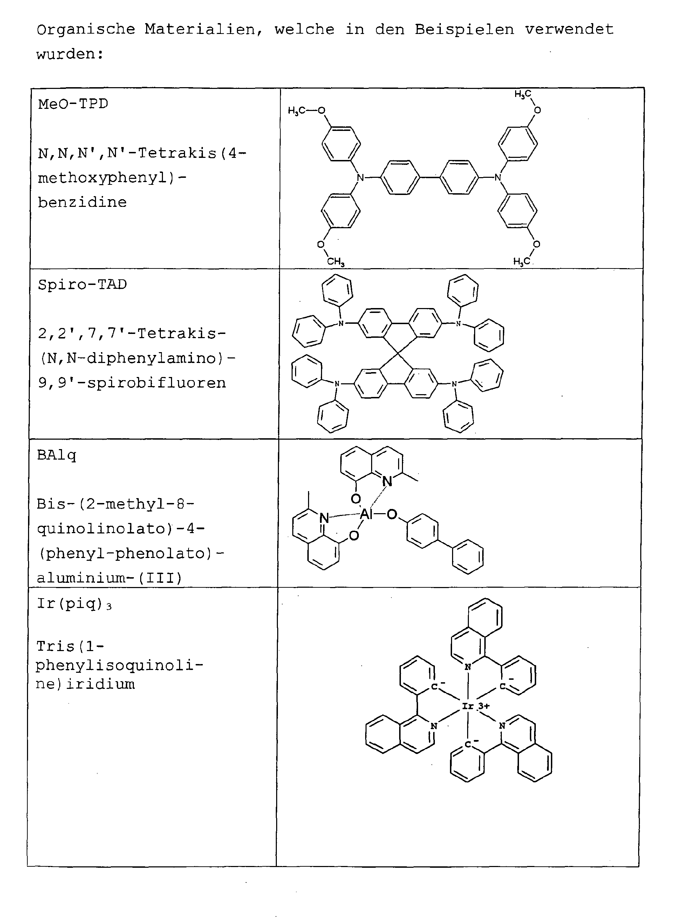

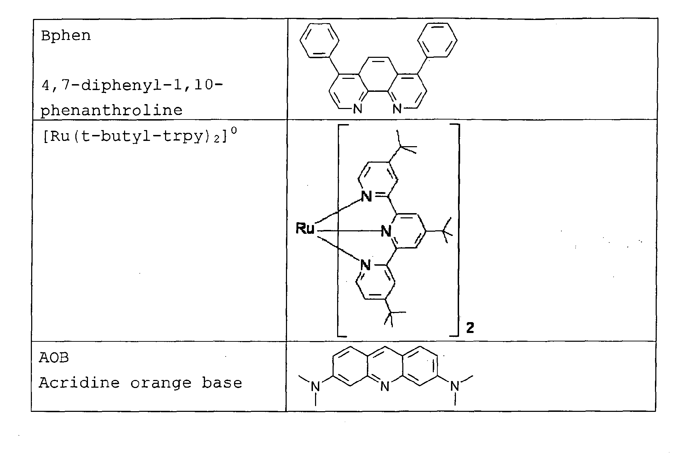

In dieser Anordnung wird BPhen als Löcher- und Exzitonenblockschicht verwendet. Mit etwa 3eV hat BPhen eine um etwa 0,9eV kleinere Elektronenaffinität als C₆₀, was sich in einer entsprechend hohen Barriere für Elektronen bemerkbar machen sollte. Dennoch zeigt diese diese Anordnung überraschenderweise sehr gute Parameter, wie einige Kenndaten in Fig. 7 und 8 zeigen.

Aus der Kombination von Ausführungsbeispiel 1 und 2 erschlie-ßen sich weitere vorteilhafte Ausgestaltungen. So

Ausführungsbeispiel 3 (Fullerenschicht als Elektrode auf beiden Seiten, transparente organische Leuchtdiode):
1. Transparentes Glassubstrat
2. Metallstreifen, Abstände 450µm, Breiten 50µm
3. mit organischen donatorartigen Molekülen dotierte Fullerenschicht
4. Löchertransportschicht
5. Elektronenblockschicht
6. Licht emittierende Schicht
7. Löcher- und Exzitonenblockschicht
8. mit organischen donatorartigen Molekülen dotierte Fullerenschicht
9. Metallstreifen, Abstände 450µm, Breiten 50µm Ausführungsbeispiel 4 (gestapelte organische Leuchtdiode, Fullerenschicht als transparente Zwischenelektrode):

1. Transparentes Glassubstrat
2. ITO
3. erste organische Leuchtdiode
4. Metallstreifen
5. dotierte Fullerenschicht
6. zweite organische Leuchtdiode
7. Aluminiumkathode

Die Stapelung kann natürlich auf mehrere Leuchtdioden erweitert werden, wobei die Metallstreifen zusammen mit der dotierten Fullerenschicht jeweils als transparente Zwischenelektrode funktionieren. Die einzelnen Leuchtdioden, welche jeweils Licht unterschiedlicher Farbe emittieren können, lassen sich separat adressieren, wenn man auch die Zwischenelektroden auf geeignete Potentiale legt. Dies wurde bereits von Burrows et al. gezeigt, welche dazu auch ein Ansteuerungsschema vorschlagen (US 1999-5,917,280). Diese separate Adressierung ist sowohl für Displayanwendungen wegen der mit der Stapelung erreichbaren höheren Pixeldichte als auch für Beleuchtungszwecke wegen der Einstellbarkeit der Farbe der Lichtquelle interessant.

Eine besondere Herausforderung ist in diesem Ausführungsbeispiel die Herausführung der Metallstreifen aus dem Stapel und deren stabile Kontaktierung ohne dabei Kurzschlüsse zu den anderen Elektroden zu verursachen. Dazu ist in Fig.6 eine Anordnung gezeigt, die diese Probleme umgeht, indem die Zwischenelektroden zu verschiedenen Seiten des Stapels herausgeführt werden. Damit werden Kurzschlüsse zwischen den einzelnen Elektroden vermieden. Mit der Zahl der gestapelten organischen Leuchtdioden nimmt auch die Höhe der Stufe zu, welche von den herausgeführten Elektroden überwunden werden muss, da der eigentliche Kontakt üblicherweise direkt auf dem Substrat aufgebracht ist. Da die Metallstreifen jedoch nur einige 10 Nanometer dick sein dürfen, entsteht mit zunehmender Höhe die Gefahr, dass die Streifen nicht mehr durchgängig sind, wenn sie über die Stufe führen. Dies wird in der vorgestellten Anordnung derart behoben, dass die Metallstreifen zwar aus dem Überlappungsbereich der Elektroden herausgehen, aber nicht über die darunterliegenden organischen Schichten hinaus. Darauf wird dann eine dicke Metallschicht aufgebracht, welche die Stufe überwindet und bis zum eigentlichen Kontakt führt. Fig.6 ist eine Draufsicht auf die Anordnung, dabei sind die Bezeichnungen folgendermaßen:
(1a), (1b), (1c) Kontakte
(2) transparente Anode (zum Beispiel ITO)
(3a) transparente Zwischenelektrode, bestehend aus Metallstreifen und dotierter Fullerenschicht
(3b) dicke Metallschicht zur Kontaktierung von (3a) mit (1b)
(4a) erste organische Leuchtdiode
(4b) zweite organische Leuchtdiode
(5) Kathode (zum Beispiel Aluminium)
(6, schraffiert) Überlappbereich der Elektroden, leuchtende Fläche

Die Ausweitung auf mehr als zwei übereinander gestapelte organische Leuchtdioden ist dadurch möglich, dass die jeweils hinzukommenden Zwischenelektroden nach anderen Seiten des Stapels gemäß der vorangehenden Erläuterung herausgeführt und kontaktiert werden. Speziell für den Fall, dass mehr als vier Elektroden und Zwischenelektroden kontaktiert werden sollen, kann es vorteilhaft sein, die organischen Schichten anstatt in rechteckiger Form in mehrseitiger Form aufzubringen, um für jede zu kontaktierende Elektrode eine möglichst kurze Kantenlinie der zu überwindenden Stufe zu ermöglichen.

## Patentansprüche

1. Elektrolumineszente Lichtemissionseinrichtung mit organischen Schichten aufgebracht auf einem Substrat, enthaltend
- mindestens eine Ladungsträgertransportschicht für Elektronen bzw. Löcher aus organischem Material
- mindestens eine Licht emittierende Schicht aus organischem Material,
**dadurch gekennzeichnet, dass** die elektrolumineszente Lichtemissionseinrichtung mindestens eine dotierte Fullerenschicht enthält.

2. Elektrolumineszente Lichtemissionseinrichtung nach Anspruch 1, **dadurch gekennzeichnet, dass** die Fullerenschicht mit organischen Molekülen dotiert ist.

3. Elektrolumineszente Lichtemissionseinrichtung nach Anspruch 1 oder 2, **dadurch gekennzeichnet, dass** in direktem Kontakt zu mindestens einer dotierten Fullerenschicht mindestens eine Metallschicht aufgebracht ist.

4. Elektrolumineszente Lichtemissionseinrichtung nach Anspruch 3, **dadurch gekennzeichnet, dass** die Metallschicht strukturiert ist.

5. Elektrolumineszente Lichtemissionseinrichtung nach Anspruch 4, **dadurch gekennzeichnet, dass** die Metallschicht durch ein Druckverfahren strukturiert ist.

6. Elektrolumineszente Lichtemissionseinrichtung nach einem der Ansprüche 1 bis 5, **dadurch gekennzeichnet, dass** mindestens eine dotierte Fullerenschicht selbst eine flächige Elektrode darstellt.

7. Elektrolumineszente Lichtemissionseinrichtung nach einem der Ansprüche 1 bis 6, **dadurch gekennzeichnet, dass** die dotierte Fullerenschicht als Ladungsträgertransportschicht verwendet wird.

8. Elektrolumineszente Lichtemissionseinrichtung nach Anspruch 7, **dadurch gekennzeichnet, dass** die dotierte Fullerenschicht als Elektronentransportschicht verwendet wird.

9. Elektrolumineszente Lichtemissionseinrichtung nach Anspruch 7 oder 8, **dadurch gekennzeichnet, dass** zwischen der dotierten Fullerenschicht und der Licht emittierenden Schicht eine Schicht verwendet wird, welche Exzitonen aus der Licht emittierenden Schicht blockiert.

10. Elektrolumineszente Lichtemissionseinrichtung nach einem der vorhergehenden Ansprüche, **dadurch gekennzeichnet, dass** eine Injektionsschicht verwendet wird.

11. Elektrolumineszente Lichtemissionseinrichtung nach Anspruch 10, **dadurch gekennzeichnet, dass** die Injektionsschicht Lithiumfluorid ist.

12. Elektrolumineszente Lichtemissionseinrichtung nach einem der vorangehenden Ansprüche, **dadurch gekennzeichnet, dass** die dotierte Fullerenschicht als mindestens eine transparente Zwischenelektrode in einer vertikal gestapelten Anordnung mehrerer organischer Leuchtdioden verwendet wird.

13. Elektrolumineszente Lichtemissionseinrichtung nach Anspruch 12, **dadurch gekennzeichnet, dass** mindestens eine Zwischenelektrode auf einem von außen wählbaren elektrischen Potential liegt.

14. Elektrolumineszente Lichtemissionseinrichtung nach Anspruch 13, **dadurch gekennzeichnet, dass** jede Elektrode nach einer anderen Seite des vertikalen Stapels organischer Leuchtdioden herausgeführt wird.

15. Elektrolumineszente Lichtemissionseinrichtung nach Ansprüchen 1-14, **dadurch gekennzeichnet, dass** die dotierten fullerenschichten durch Koverdampfen des Fullerens mit einer Dotiersubstanz aufgebracht werden.

## Geänderte Patentansprüche

### Geänderte Patentansprüche gemäss Regel 86(2) EPÜ.

**1.** Elektrolumineszente Lichtemissionseinrichtung mit organischen Schichten aufgebracht auf einem Substrat, enthaltend mindestens eine Ladungsträgertransportschicht für Elektronen bzw. Löcher aus organischem Material und mindestens eine Licht emittierende Schicht aus organischem Material, **gekennzeichnet durch** mindestens eine dotierte Fullerenschicht, die als eine flächige Elektrode oder als eine Ladungsträgertransportschicht gebildet ist.

**2.** Elektrolumineszente Lichtemissionseinrichtung nach Anspruch 1, **dadurch gekennzeichnet, dass** die mindestens eine dotierte Fullerenschicht mit organischen Molekülen dotiert ist.

**3.** Elektrolumineszente Lichtemissionseinrichtung nach Anspruch 1 oder 2, **dadurch gekennzeichnet, dass** in direktem Kontakt mit der mindestens einer dotierten Fullerenschicht mindestens eine Metallschicht aufgebracht ist.

**4.** Elektrolumineszente Lichtemissionseinrichtung nach Anspruch 3, **dadurch gekennzeichnet, dass** die mindestens eine Metallschicht strukturiert ist.

**5.** Elektrolumineszente Lichtemissionseinrichtung nach einem der Ansprüche 1 bis 4, **dadurch gekennzeichnet, dass** die mindestens eine dotierte Fullerenschicht als Elektronentransportschicht gebildet ist.

**6.** Elektrolumineszente Lichtemissionseinrichtung nach einem der Ansprüche 1 bis 5, **dadurch gekennzeichnet, dass** zwischen der mindestens einen dotierten Fullerenschicht und der mindestens einen Licht emittierenden Schicht eine Schicht angeordnet ist, welche Exzitonen aus der mindestens einen Licht emittierenden Schicht blockiert, wenn die mindestens eine dotierte Fullerenschicht als Ladungsträgertransportschicht gebildet ist.

**7.** Elektrolumineszente Lichtemissionseinrichtung nach einem der vorhergehenden Ansprüche, **dadurch gekennzeichnet, dass** eine Injektionsschicht gebildet ist.

**8.** Elektrolumineszente Lichtemissionseinrichtung nach Anspruch 7, **dadurch gekennzeichnet, dass** die Injektionsschicht aus Lithiumfluorid ist.

**9.** Verfahren zum Herstellen einer elektrolumineszenten Lichtemissionseinrichtung mit organischen Schichten, bei dem die organischen Schichten auf einem Substrat aufgebracht werden, die organischen Schichten mindestens eine Ladungsträgertransportschicht für Elektronen bzw. Löcher aus organischem Material und mindestens eine Licht emittierende Schicht aus organischem Material gebildet werden, **dadurch gekennzeichnet, dass** die organischen Schichten mindestens eine dotierte Fullerenschicht aufweisend gebildet werden, die als eine flächige Elektrode oder als eine Ladungsträgertransportschicht hergestellt wird.

**10.** Verfahren nach Anspruch 9, **dadurch gekennzeichnet, dass** die mindestens eine dotierte Fullerenschicht mittels Coverdampfen des Fullerens mit einer Dotiersubstanz aufgebracht wird.

**11.** Elektrolumineszente, Licht emittierende Vorrichtung mit einer vertikal gestapelten Anordnung mehrerer organischer Leuchtdioden, die jeweils organische, auf einem Substrat aufgebrachte Schichten aufweisen, wobei die organischen Schichten mindestens eine Ladungsträgertransportschicht für Elektronen bzw. Löcher aus organischem Material und mindestens eine Licht emittierende Schicht aus organischem Material umfassen, **dadurch gekennzeichnet, dass** mindestens eine dotierte Fullerenschicht als mindestens eine transparente Zwischenelektrode zwischen benachbarten organischen Leuchtdioden gebildet ist.

**12.** Vorrichtung nach Anspruch 11, **dadurch gekennzeichnet, dass** in direktem Kontakt mit der mindestens einen Fullerenschicht eine strukturierte gedruckte Metallschicht gebildet ist, die mittels eines Druckverfahrens aufgebracht ist.
